(19) Europäisches Patentamt
European Patent Office
Office européen des brevets

(11) **EP 2 388 598 A2**

(12) **EUROPEAN PATENT APPLICATION**

(43) Date of publication:
**23.11.2011 Bulletin 2011/47**

(51) Int Cl.:
***G01R 19/00*** *(2006.01)*

(21) Application number: **11159399.2**

(22) Date of filing: **23.03.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **18.05.2010 JP 2010113885
18.05.2010 JP 2010113886**

(71) Applicant: **Panasonic Corporation
Kadoma-shi
Osaka 571-8501 (JP)**

(72) Inventors:
• **Kameda, Koji**
**Osaka 540-6207 (JP)**
• **Shiba, Fumikazu**
**Osaka 540-6207 (JP)**
• **Mori, Hirokazu**
**Osaka 540-6207 (JP)**

(74) Representative: **Schwabe - Sandmair - Marx
Patentanwälte
Stuntzstraße 16
81677 München (DE)**

(54) **Motor current detecting IC and motor current detector or motor control apparatus using the same**

(57) A motor current detecting IC of the invention includes a comparing circuit having a detection value setting terminal which sets a detection current value, a current signal amplifying circuit having a differential amplifying circuit connected to the comparing circuit, one pair of input terminals connected to the differential amplifying circuit and an output terminal connected to an output of the differential amplifying circuit, and a power supply terminal which supplies a power supply voltage to the current signal amplifying circuit. The comparing circuit compares a voltage determined by a detection value setting resistor connected to the detection value setting terminal with a voltage input to any one of the pair of input terminals of the differential amplifying circuit or a voltage of the output terminal of the differential amplifying circuit and outputs a comparison result. For this reason, reductions in size and cost of a motor control circuit, a motor control apparatus, and various apparatuses using the motor control apparatuses can be realized.

FIG. 1

EP 2 388 598 A2

**Description**

**BACKGROUND OF THE INVENTION**

**1. Field of the Invention**

The present invention relates to a motor current detecting IC and a motor current detector or a motor control apparatus using the same.

**2. Background Art**

As a conventional control apparatus for a 3-phase synchronous motor (hereinafter, abbreviated as a "motor") such as a 3-phase induction motor or a brushless motor, an inverter circuit is generally used.

A control circuit arranged in the control apparatus detects a winding current of a motor by the following method to control a rotating speed of the motor.

A first method is a method of directly detecting a winding current of a motor by using a current detector such as a hall sensor on a cable run (wire) connected to a winding of the motor. In general, 2 circuits are frequently used in a three-phase motor. According to this method, a winding current of a motor can be accurately detected. In a sensor using a hall element, insulation between a winding of a motor and a control circuit is possible.

However, a current detector (or a detecting circuit) has a relatively large size and is expensive. For this reason, in general, the first method is used in a control apparatus such as a control circuit for an industrial servo motor which is required to be accurately controlled.

A second method is a method of amplifying voltage drop of a shunt resistor for detecting a current serially inserted on a negative power supply side of a switching element of a - (negative) side of an inverter circuit .to detect a winding current of a motor. More specifically, according to the method, a winding current of the motor is detected by a change in current flowing in the shunt resistor at ON/OFF timings of switching elements or the like of the inverter circuit. In this case, since a timing at which a current is detected needs to be controlled in the control circuit, and the control circuit is generally controlled by a microcomputer or the like. At this time, since a potential of a detected signal is a negative potential of the inverter circuit, no problem is posed when the control circuit is placed at the same potential. However, when the control circuit is placed at a potential insulated from the inverter circuit, a circuit which insulates the control circuit and the inverter circuit from each other is necessary.

However, according to the second method, a current detecting circuit can be configured at relatively low cost. For this reason, the second method is popularly used in control of an inverter for driving an industrial 3-phase induction motor or a home-use electric motor for a washing machine, an air conditioner, or the like.

The second method is disclosed in, for example, Unexamined Japanese Patent Publication No. 2008-054812 (Patent Literature 1).

A motor drive apparatus used in the heat pump laundry and drying machine disclosed in Patent Literature 1 will described below with reference to the drawings.

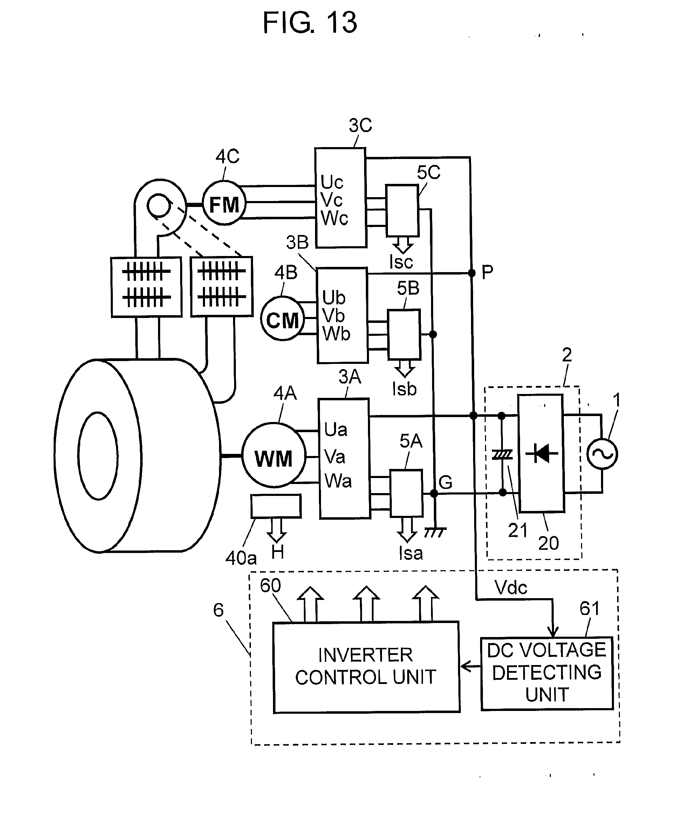

Fig. 13 is a block diagram showing a conventional motor drive apparatus. As shown in Fig. 13, the motor drive apparatus includes at least, AC power supply 1, rectifying circuit 2, a plurality of inverter circuits, control unit 6, and a plurality of motors. Rectifying circuit 2 includes full-wave rectifying circuit 20 and electrolytic capacitor 21 and converts an AC power into a DC power to configure a DC power supply. The plurality of inverter circuits include first inverter circuit 3A, second inverter circuit 3B, and third inverter circuit 3C, and convert the DC power obtained by rectifying circuit 2 into a 3-phase AC power. The plurality of motors include, for example, rotating drum drive motor 4A, heat pump compressor motor 4B, and blower fan motor 4C, and the like. The plurality of motors are driven by 3-phase AC powers obtained by first inverter circuit 3A, second inverter circuit 3B, and third inverter circuit 3C, respectively.

Control unit 6 has inverter control unit 60 and DC voltage detecting unit 61 and detects and controls currents of the motors. More specifically, DC voltage detecting unit 61 detects currents Isa, Isb, and Isc of the motors by first current detecting unit 5A, second current detecting unit 5B, and third current detecting unit 5C connected to emitter terminals of lower arm switching transistors of first inverter circuit 3A, second inverter circuit 3B, and third inverter circuit 3C. Inverter control unit 60 is configured by a high-speed processor such as a microcomputer which includes a plurality of PWM control units (not shown) which PWM-control first inverter circuit 3A, second inverter circuit 3B, and third inverter circuit 3C and a plurality of high-speed A/D converters (not shown), and simultaneously controls first inverter circuit 3A, second inverter circuit 3B, and third inverter circuit 3C. In this manner, rotating drum drive motor 4A, compressor motor 4B, and blower fan motor 4C are controlled at different rotating speeds, respectively.

First inverter circuit 3A controls rotating drum drive motor 4A by position H of a permanent magnet of a rotor of rotating drum drive motor 4A detected by position detecting unit 40a and current Isa of a motor of rotating drum drive motor 4A detected by first current detecting unit 5A.

Like first inverter circuit 3A, second inverter circuit 3B controls compressor motor 4B, and third inverter circuit 3C controls blower fan motor 4C.

First current detecting unit 5A, second current detecting unit 5B, and third current detecting unit 5C detect currents of a motor by a 3-shunt current detecting system configured by three shunt resistors and a current signal amplifying unit. The basic configurations of first current detecting unit 5A, second current detecting unit 5B, and third current detecting unit 5C are the same, and only have shunt resistances varying depending a current of the motor.

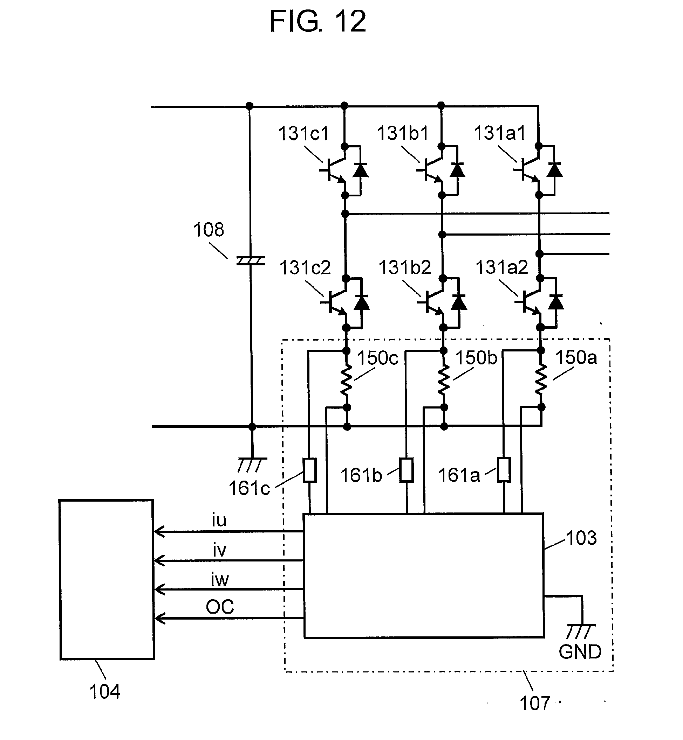

More specifically, as will be described below with reference to Fig. 12, first current detecting unit 5A, second current detecting unit 5B, and third current detecting unit 5C are configured such that one terminals of shunt resistors are connected to emitter terminals (Nu, Nv, and Nw) of lower arm transistors of a full-bridge 3-phase inverter circuit and other terminals of the shunt resistors are connected to a negative G terminal (GND) of a DC power supply. The system is called a 3-shunt system because the system is configured by three shunt resistors.

An inverter circuit of a conventional motor drive apparatus will be described below in detail with reference to the drawings.

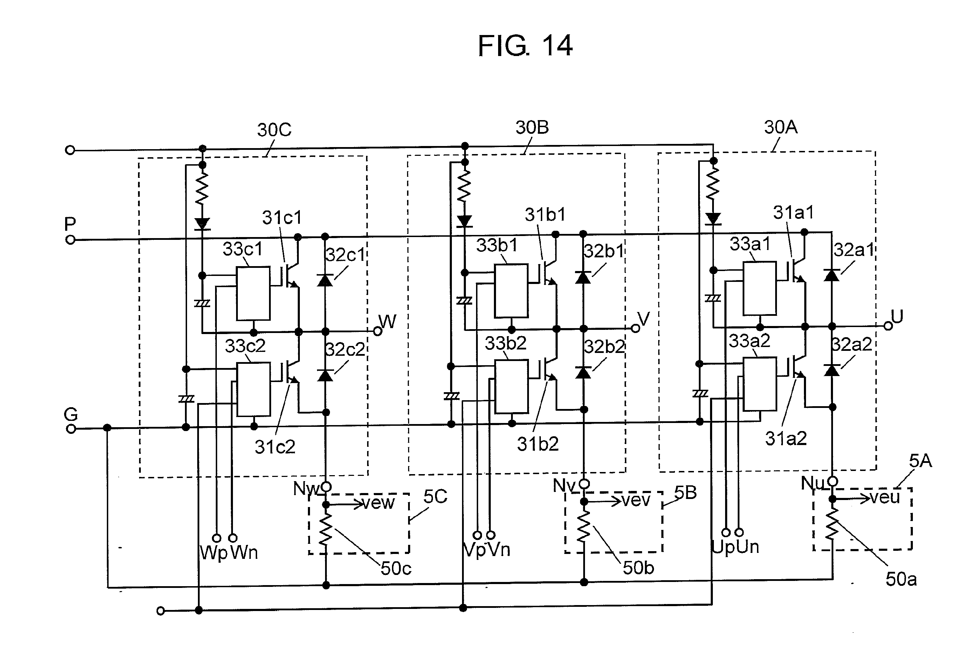

Fig. 14 is a circuit diagram of an inverter circuit of a conventional motor drive apparatus. As shown in Fig. 14, the inverter circuit is configured by a power module including U-phase arm 30A, V-phase arm 30B, W-phase arm 30C, and a control IC (not shown).

U-phase arm 30A is configured such that a parallel connector body between upper arm transistor 31a1 configured by an insulating gate bipolar transistor (hereinafter, abbreviated as an "IGBT") and anti-parallel diode 32a1 and a parallel connector body between lower arm transistor 31a2 configured by an IGBT and anti-parallel diode 32a2 are connected in series with each other. The collector terminal of upper arm transistor 31a1 is connected to terminal P on a positive potential side of the DC power supply, and the emitter terminal of upper arm transistor 31a1 is connected to output terminal U to the motor. Furthermore, emitter terminal Nu of lower arm transistor 31a2 is connected to terminal G on a negative potential side of the DC power supply through U-phase shunt resistor 50a configuring first current detecting unit 5A.

Upper arm transistor 31a1 is driven by upper arm drive signal Up through upper arm gate drive circuit 33a1, and lower arm transistor 31a2 is switching-controlled by lower arm drive signal Un through lower arm gate drive circuit 33a2.

Similarly, V-phase arm 30B is configured such that a parallel connector body between upper arm transistor 31b1 and anti-parallel diode 32b1 and a parallel connector body between lower arm transistor 31b2 and anti-parallel diode 32b2 are connected in series with each other. The collector terminal of upper arm transistor 31b1 is connected to terminal P on a positive potential side of the DC power supply, and the emitter terminal of upper arm transistor 31b1 is connected to output terminal V to the motor. At this time, upper arm transistor 31b1 is driven by upper arm drive signal Vp through upper arm gate drive circuit 33b1, and lower arm transistor 31b2 is switching-controlled by lower arm drive signal Vn through lower arm gate drive circuit 33b2.

W-phase arm 30C is configured such that a parallel connector body between upper arm transistor 31c1 and anti-parallel diode 32c1 and a parallel connector body between lower arm transistor 31c2 and anti-parallel diode 32c2 are connected in series with each other. The collector terminal of upper arm transistor 31c1 is connected to terminal P on a positive potential side of the DC power supply, and the emitter terminal of upper arm transistor 31c1 is connected to output terminal W to the motor. ' At this time, upper arm transistor 31c1 is driven by upper arm drive signal Wp through upper arm gate drive circuit 33c1, and lower arm transistor 31c2 is switching-controlled by lower arm drive signal Wn through lower arm gate drive circuit 33c2.

Like U-phase arm 30A, emitter terminals Nv and Nw of lower arm transistors 31b2 and 31c2 of V-phase arm 30B and W-phase arm 30C are connected to one terminals of V-phase shunt resistor 50b and W-phase shunt resistor 50c constituting second current detecting unit 5B and third current detecting unit 5C. The other terminals of V-phase shunt resistor 50b and W-phase shunt resistor 50c are connected to terminal G on a negative potential side of the DC power supply.

The lower arm transistor is configured by an IGBT or a power MOSFET to make it possible to perform switching control by control of a gate voltage. At this time, when a resistance is set such that a voltage generated by a shunt resistor connected to an emitter terminal of an IGBT or a source terminal of a power MOSFET is 1 V or less, the lower arm transistor can be switching-controlled by controlling the gate voltage without much influence on a switching operation. As a result, voltage veu of U-phase shunt resistor 50a, voltage vev of V-phase shunt resistor 50b, and voltage vew of W-phase shunt resistor 50c are detected to make it possible to detect an output current from an inverter circuit, i.e., a current of a motor.

With reference to the drawings, a description will be given below of current signal amplifying units of first current detecting unit 5A, second current detecting unit 5B, and third current detecting unit 5C which amplify a current of a motor detected by a shunt resistor in a conventional motor drive apparatus.

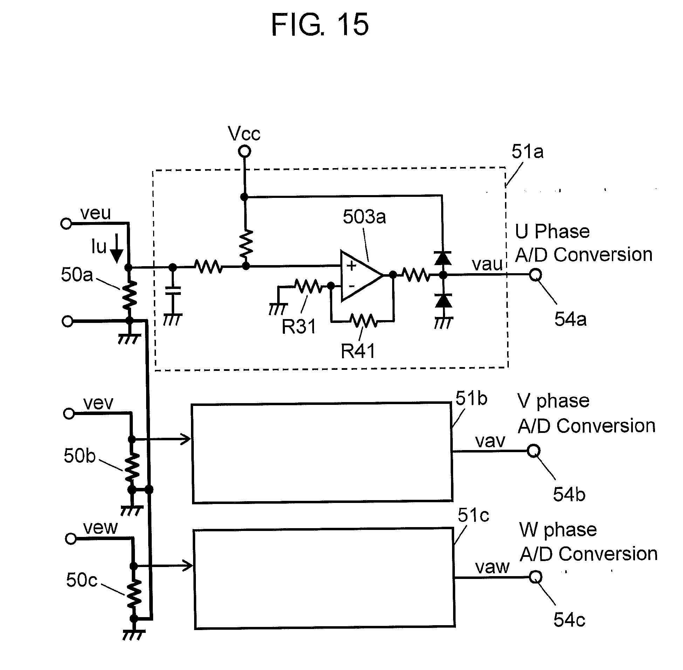

Fig. 15 is a circuit diagram of a current signal amplifying unit of each current detecting unit of the conventional motor drive apparatus. As shown in Fig. 15, current signal amplifying units 51a, 51b, and 51c convert current signals detected by U-phase shunt resistor 50a, V-phase shunt resistor 50b, and W-phase shunt resistor 50c into voltages by non-inversion amplifier 503a and output the voltages to control unit 6 through U-phase output terminal 54a, V-phase output terminal 54b, and W-phase output terminal 54c. At this time, the converted voltages are converted into voltages at DC voltage levels which can be detected by an A/D converter built in a processor such as a microcomputer of control unit, and the resultant voltages are output.

However, first current detecting unit 5A of the conventional motor drive apparatus is configured by: U-phase shunt resistor 50a, V-phase shunt resistor 50b, and W-phase shunt resistor 50c which detect a current of a motor as a voltage; non-inversion amplifier 503a such as an operational amplifier; a plurality of resistors R31 and R41 which determine a gain of non-inversion amplifier 503a; and current signal amplifying unit 51a configured by components such as a capacitor and a diode. Second current detecting unit 5B and third current detecting unit 5C are similarly configured. For this reason, a large number of constituent components and a large mounting area are required, which increases the cost.

For this reason, in general, the current detecting unit having the above configuration is made into a module by, for example, a hybrid IC or the like. Although the current detecting unit can be reduced in size to some extent by making it into a module, a further reduction in size is limited, and the cost also cannot be reduced.

The current detecting circuit is configured by combining respective components to each other for the following reasons.

The first reason: a current of a motor flows with the positive and negative polarities. For this reason, currents of both the positive and negative polarities also flow in a shunt resistance which detects a current of the motor of the current detecting circuit. As a result, a positive or negative voltage is generated across both the ends of the shunt resistor depending on the polarity of the current of the motor. For this reason, in general, a voltage falling within the range of positive and negative voltages is normally input to an input terminal of an AMP constituting an amplifier.

However, in order to input a voltage across both the ends of the shunt resistor to the amplifier, an AMP operated by both the positive and negative power supplies needs to be used in the current detecting circuit. Alternatively, the current detecting circuit has to be configured not to apply a negative voltage generated by the shunt resistor to the AMP.

The second reason: in an abnormal state in which a shunt resistor which detects a current of, for example, a motor is open, a high voltage which drives the motor is applied to the amplifier, and a voltage higher than a power supply voltage of an AMP constituting the amplifier may be applied to the AMP. As a result, a resin mold of the AMP may explode, fire, and emit smoke.

In order to avoid this, the current detecting circuit is configured such that, of resistors which sets gain of an amplifier, a resistor connected between the shunt resistor and the AMP suppresses a current flowing in the AMP in an abnormal state and a trouble is minimized by fusing the resistor.

For the above reasons, since a conventional current detecting circuit has a large number of components and requires a large mounting area, the cost also increases. Even though the current detecting circuit is made into a module to plan to reduce in size the current detecting circuit, the cost of the current detecting circuit is higher.

## SUMMARY OF THE INVENTION

A motor current detecting IC of the invention includes a comparing circuit having a detection value setting terminal which sets a detection current value, a current signal amplifying circuit having a differential amplifying circuit connected to the comparing circuit, one pair of input terminals connected to the differential amplifying circuit and an output terminal connected to an output of the differential amplifying circuit, and a power supply terminal which supplies a power supply voltage to the current signal amplifying circuit. The comparing circuit compares a voltage determined by a detection value setting resistor connected to the detection value setting terminal with a voltage input to any one of one pair of input terminals of the differential amplifying circuit or a voltage of the output terminal of the differential amplifying circuit and outputs a comparison result.

In this manner, the size, the number of components, and a mounting area of the current signal amplifying circuit can be reduced to make it possible to realize the motor current detecting IC at low cost.

A motor control apparatus according to the present invention is configured by the motor current detecting IC according to the present invention. In this manner, a small-sized motor control apparatus can be realized at low cost.

A motor current detector according to the present invention is configured by the motor current detecting IC according to the present invention and a current detecting low-resistance resistor connected between one pair of input terminals of the differential amplifying circuit of the current signal amplifying circuit. In this manner, a motor current detector having a small size, a small number of components, a small mounting area, and a low cost can be realized.

A motor control apparatus according to the present invention is configured by using the motor current detector according to the present invention. In this manner, a small-sized motor control apparatus can be realized at low cost.

**BRIEF DESCRIPTION OF DRAWINGS**

Fig. 1 shows a block diagram of a motor control apparatus using a motor current detecting IC according to a first embodiment of the present invention.

Fig. 2 shows a block diagram of the motor current detecting IC according to the first embodiment.

Fig. 3 shows a block diagram of another example of the motor current detecting IC according to the first embodiment of the present invention.

Fig. 4 shows a block diagram of a motor control apparatus using a motor current detecting IC according to a second embodiment of the present invention.

Fig. 5 shows a block diagram of the motor current detecting IC according to the second embodiment.

Fig. 6 shows a block diagram of another example of the motor current detecting IC according to the second embodiment of the present invention.

Fig. 7 shows an explanatory diagram of a protecting unit of a motor current detecting IC according to a fifth embodiment of the present invention.

Fig. 8 shows an explanatory diagram of a protecting unit of a motor current detecting IC according to a sixth embodiment of the present invention.

Fig. 9 shows an explanatory sectional view of a structure of a motor current detecting IC according to a seventh embodiment of the present invention.

Fig. 10A shows an explanatory partial plan view of a wiring near a bonding pad of a general IC.

Fig. 10B shows an explanatory partial plan view of a wiring having a blocking unit near a bonding pad of a motor current detecting IC according to an eighth embodiment of the present invention.

Fig. 11 shows a block diagram of a motor control apparatus using a motor current detector according to a ninth embodiment of the present invention.

Fig. 12 shows a block diagram of a motor control apparatus using a motor current detector according to a tenth embodiment of the present invention.

Fig. 13 shows a block diagram of a conventional motor drive apparatus.

Fig. 14 shows a circuit diagram of an inverter circuit of a conventional motor drive apparatus.

Fig. 15 shows a circuit diagram of a current signal amplifying unit of each current detecting unit of the conventional motor drive apparatus.

**DETAILED DESCRIPTION OF THE INVENTION**

Embodiments of the present invention will be described below with reference to the drawings. Note that the present invention is not limited to the embodiments.

**(FIRST EMBODIMENT)**

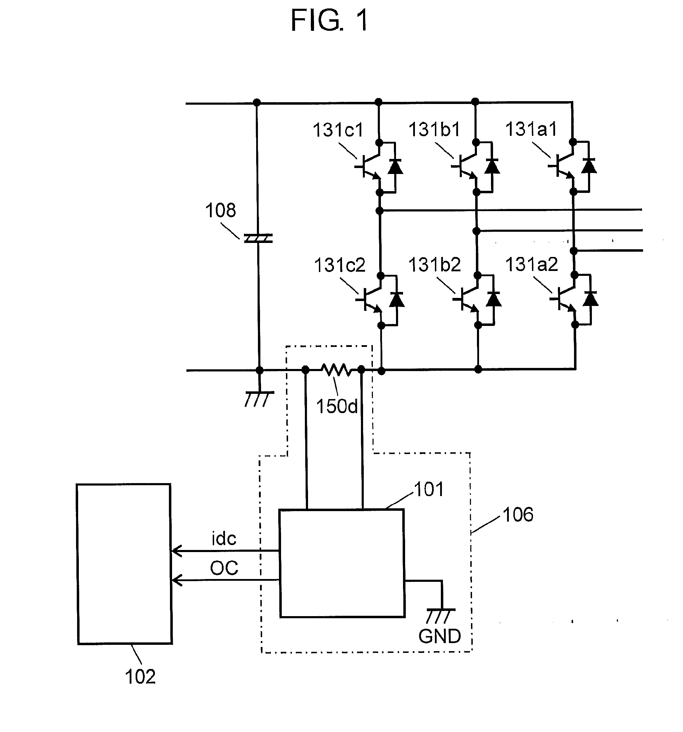

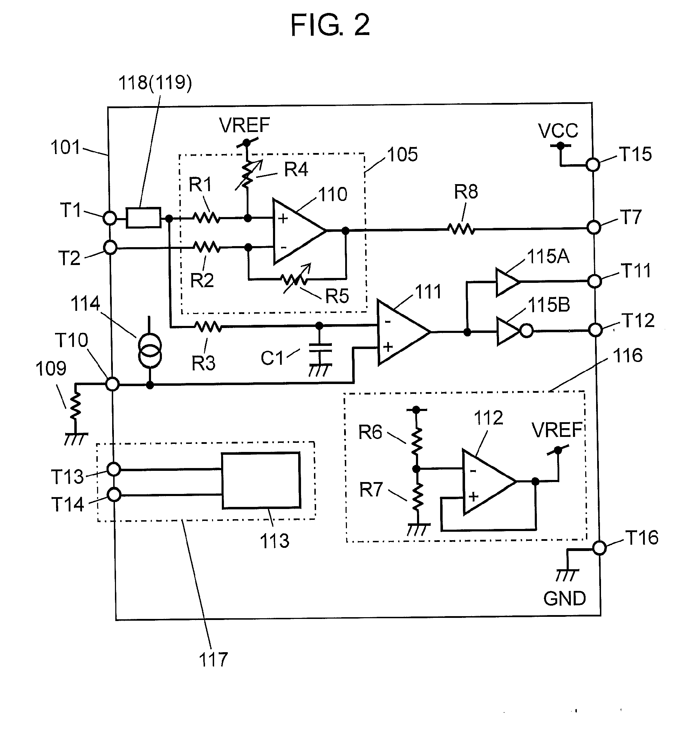

Fig. 1 is a block diagram of a motor control apparatus using a motor current detecting IC according to a first embodiment of the present invention. Fig. 2 is a block diagram of the motor current detecting IC according to the first embodiment. In the first embodiment, especially in Fig. 2, a configuration related to parts, i.e., differential amplifying circuit 105, input terminals T1 and T2 and output terminal T7 of differential amplifying circuit 105, comparing circuit 111, and detection value setting terminal T10 and output terminals T11 and T17 of comparing circuit 111 will be mainly described.

As shown in Fig. 1, an inverter circuit for driving a 3-phase motor is configured by a total of 6 switching elements, i.e., 3 parallel arranged sets of pairs of switching element 131a1 and switching element 131a2, switching element 131b1 and switching element 131b2, and switching element 131c1 and switching element 131c2 each pair of which are connected in series with each other. At this time, as the switching element, for example, an IGBT is used.

A connection point to which one pair of switching elements, for example, an emitter side (lower side) of switching element 131a1 and a collector side (upper side) of switching element 131a2 are connected is connected to a motor (not shown). Furthermore, all emitter sides of lower switching elements 131a2, 131b2, and 131c2 connected in series with each other are commonly connected to each other, connected to one terminal of current detecting low-resistance resistor 150d for detecting a current, and the other terminal of current detecting low-resistance resistor 150d is connected to a negative side of electrolytic capacitor 108. Both the ends of electrolytic capacitor 108 are connected to a rectifying circuit which rectifies a commercial AC power supply (not shown in Fig. 1). At this time, when a voltage doubler rectifying circuit having, for example, a single-phase AC of 100 V or a full-wave rectifying circuit having a single-phase or three-phase AC of 200 V is connected, a DC voltage of about 280 V is applied across both the ends of electrolytic capacitor 108.

Both the ends of current detecting low-resistance resistor 150d are connected to motor current detecting IC 101, and motor current detector 106 is configured by current detecting low-resistance resistor 150d and motor current detecting IC 101. The example in which motor current detector 106 is incorporated in the motor control apparatus has been described above. However, the motor control apparatus can also be configured as a single motor current detector by current detecting low-resistance resistor 150d and motor current detecting IC 101.

As shown in Fig. 1, the control circuit 102 is configured by mainly using, for example, a microcomputer (not shown), and current detecting signal idc output from motor current detector 106 is input to an A/D converting port of the microcomputer. Control circuit 102 controls the gate signals of switching elements 131a1, 131a2, 131b1, 131b2, 131c1, and 131c2 of the inverter circuit to drive the motor. At this time, when, for example, switching elements 131a1, 131b1, and 131c2 are turned on and switching elements 131a2, 131a2, and 131c1 are turned off, a motor current which drives a motor is detected as a current flowing from a winding of a motor connected to switching element 131c1 and switching element 131c2 toward the inverter circuit through current detecting low-resistance resistor 150d for detecting a current and the motor current detecting IC. Furthermore, when, for example, switching elements 131a1, 131b2, and 131c2 are turned on and switching elements 131a2, 131b1, and 131c1 are turned off, a current of a winding of a motor connected to switching element 131a1 and switching element 131a2 through current detecting low-resistance resistor 150d for detecting a current and the motor current detecting IC is detected as a current flowing from the inverter circuit toward the winding of the motor. In this case, control circuit 102 needs to determine where a detected current flows depending on an operation of the inverter circuit and a direction of a current of the motor to be detected.

Furthermore, control circuit 102 controls the motor by using a wiring current of the motor and information of another detector (not shown) (for example, a position sensor or a speed sensor attached to the motor, a sensor for a power supply voltage, or the like).

As shown in Fig. 2, in motor current detecting IC 101, a voltage generated across both the ends of current detecting low-resistance resistor 150d is amplified by AMP 110 of differential amplifying circuit 105 and output to control circuit 102 as analog current detecting signal idc. Current detecting signal idc input to the microcomputer or the like of control circuit 102 is A/D-converted by control circuit 102 and then used as a current detection value for speed control, torque control, and the like of the motor.

Motor current detecting IC 101 having a differential amplifying circuit will be described below in detail with reference to Fig. 2.

As shown in Fig. 2, both the ends of current detecting low-resistance resistor 150d of the inverter circuit are connected to input terminals T1 and T2 of motor current detecting IC 101. The following description is made on the assumption that input terminal T1 is connected to the right side (for example, the emitter side of a lower switching element of an IGBT or the like) of current detecting low-resistance resistor 150d shown in Fig. 1 and input terminal T2 is connected to the left side (electrolytic capacitor 108) of current detecting low-resistance resistor 150d shown in Fig. 1.

In this case, an input voltage to input terminal T1 is represented by $V_{T1}$ [V], an input voltage to input terminal T2 is represented by $V_{T2}$ [V], an

output voltage to output terminal T7 is represented by $V_{OUT}$ [V], a reference voltage on a $V_{REF}$ side of resistor R4 in Fig. 2 is represented by $V_{REF}$ [V], and resistances of resistors $R_1$, R2, R4, and R5 are represented by $R_1$ [Ω], $R_2$ [Ω], $R_4$ [Ω], and $R_5$ [Ω]. In this case, output voltage $V_{OUT}$ [V] is given by the

following equation:

$$V_{OUT} = \{(R_1R_2 + R_1R_5)V_{REF} + (R_2R_4 + R_4R_5)V_{T1} + (\text{-}R_1R_5 \text{-} R_4R_5)V_{T2}\}/\{R_2(R_1 + R_4)\} \cdots (1)$$

When a differential amplifying circuit is to be generally configured, values of resistors $R_1$, R2, R4, and R5 are set to satisfy $R_1 = R_2$ and $R_4 = R_5$ (or $R_1 : R_4 = R_2 : R_5$). When the relation is put in equation (1), output voltage $V_{OUT}$ [V] is given by the following equation:

$$V_{OUT} = V_{REF} + (V_{T1} \text{-} V_{T2}) R_4/R_1 \cdots (2)$$

When reference voltage $V_{REF}$ is supposed to be a virtual GND, a voltage amplified at gain $(R_4/R_1)$ is output to output terminal T7 with reference to the virtual GND.

A current signal amplifying circuit is configured by differential amplifying circuit 105, one pair of input terminals T1 and T2 connected to differential amplifying circuit 105, and output terminal T7 connected to an output of differential amplifying circuit 105.

Design values of constants of the components of the motor drive apparatus in the configuration shown in Fig. 1 will be described while exemplifying a case in which a motor is driven at a maximum value of a drive current which is $\pm 6$ A (zero-peak).

In this case, a voltage drop by current detecting low-resistance resistor 150d is preferably set to 1 V or less not to influence operations of switching elements 131a2, 131b2, and 131c2 configured by, for example, IGBTs which constitute an inverter circuit. For example, when a resistance of current detecting low-resistance resistor 150d is set to 50 m$\Omega$, a voltage drop by the maximum current of the motor is given by 6 A $\times$ 50 m$\Omega$ = 0.3 V. As a result, even though the drive current value of the motor exceeds 6 A, the switching element of the inverter circuit can be easily driven.

When it is supposed that current detecting signal idc input to control circuit 102 is A/D-converted by the A/D converter of the microcomputer, a voltage which can be input is generally 0 V to 5 V. For this reason, output voltage $V_{OUT}$ of the differential amplifying circuit is preferably set within a range of $\pm 2.5$ V with reference to 2.5 V which is a central voltage of the A/D converter. For this reason, reference voltage $V_{REF}$ in motor current detecting IC 101 is set to 2.5 V. Specifically, in reference voltage generating unit 116 configured by resistors R6 and R7 and AMP 112 shown in Fig. 2, resistors R6 and R7 are set such that reference voltage $V_{REF}$ is 2.5 V. For example, when power supply voltage Vcc of motor current detecting IC 101 is +5 V, the resistances of resistor R6 and resistor R7 are made equal to each other to make it possible to set reference voltage $V_{REF}$ to 2.5 V.

In the above example, a volage of 0.3 V is input across input terminals T1 and T2 of motor current detecting IC 101 when a maximum current of 6 A flows in the motor. Therefore, in order to set an amplitude of a voltage of current detecting signal idc to 2.5 V or less, for example, the resistances in Fig. 2 are set to $R_1 = R_2 = 40$ k$\Omega$ and $R_4 = R_5 = 200$ k$\Omega$, and a gain of the differential amplifying circuit is set to 200 k$\Omega$/40 k$\Omega$ = 5 times. In this manner, an amplitude of output terminal T7 when the maximum current is 6 A is given by 0.3 V $\times$ 5 = 1.5 V.

As shown in Fig. 1, motor current detecting IC 101 according to the first embodiment has an overcurrent detecting circuit configured by a comparing circuit (comparator) which detects a current level of an overcurrent or the like, and outputs detected overcurrent detecting signal OC to control circuit 102.

A configuration and an operation of the overcurrent detecting circuit which detects a current level will be described below with reference to Figs. 1 and 2.

As shown in Fig. 2, in the overcurrent detecting circuit, a voltage is input from input terminal T1 of differential amplifying circuit 105 to, for example, a (negative) side serving as one input terminal of comparing circuit 111 through a low-pass filter configured by resistor R3 and capacitor C1. A voltage determined by current source 114 and detection value setting resistor 109 connected between detection value setting terminal T10 and a circuit GND is input to, for example, a + (positive) side serving as the other input terminal of comparing circuit 111. At this time, an overcurrent value to be detected is set by a resistance of detection value setting resistor 109.

More specifically, when the resistance of current detecting low-resistance resistor 150d shown in Fig. 1 is set to 50 m$\Omega$ and the maximum value of a current of the motor is 6 A, a description will be made on the assumption that a level of an overcurrent to be detected by comparing circuit 111 is set to 8 A.

The resistance or the like of, for example, detection value setting resistor 109 is set such that an output from comparing circuit 111 is inverted when 50 m$\Omega$ $\times$ 8 A = 0.4 V. For example, when an output current from current source 114 is assued to be 100 $\mu$A, a resistor having a resistance of 0.4 V/100 $\mu$A = 4.0 k$\Omega$ is connected between detection value setting terminal T10 and the circuit GND as detection value setting resistor 109. In this manner, when an overcurrent of 8 A flows in current detecting low-resistance resistor 150d having a resistance of 50 m$\Omega$, a voltage of 0.4 V is generated at input terminal T1 of differential amplifying circuit 105 and input to one input terminal of comparing circuit 111. Comparing circuit 111 compares the voltage input to one input terminal of comparing circuit 111 with a voltage (0.4 V) set by detection value setting resistor 109 and input to the other input terminal of comparing circuit 111. At this time, when the voltage input to one input terminal of comparing circuit 111 is 0.4 V or more, an output from comparing circuit 111 is inverted to make it possible to detect flowing of an overcurrent of 8 A.

More specifically, when a voltage detected at input terminal T1 of differential amplifying circuit 105 by current detecting low-resistance resistor 150d reaches a value determined by a resistance of detection value setting resistor 109 connected to detection value setting terminal T10 of comparing circuit 111, comparing circuit 111 outputs a Low signal from output terminal T11 through buffer circuit 115A. At the same time, comparing circuit 111 outputs a High signal from output terminal T12 through inverting circuit 115B.

The output Low signal or the output High signal is input to control circuit 102 as overcurrent detecting signal OC, and can be used to protect the switching element of, for example, the inverter circuit or prevent the winding of the motor from being short-circuited. More specifically, when overcurrent detecting signal OC is input to control circuit 102, control circuit 102 immediately blocks gate signals of switching elements 131a1, 131a2, 131b1, 131b2, 131c1, and 131c2 of the inverter circuit to prevent switching elements 131a1, 131a2, 131b1, 131b2, 131c1, and 131c2 from being broken down.

Since current detecting signal idc output to output terminal T7 is used for motor control, a current waveform of the motor needs to be faithfully detected. For this reason, in order to reduce an influence of noise or the like, both the ends of the current detecting low-resistance resistor are connected to differential amplifying circuit 105 configured by AMP 110 and resistors therearound to input the signal.

On the other hand, overcurrent detection in comparing circuit 111 is to detect a level of a current. Therefore, instead of the differential configuration, a low-pass filter is configured by resistor R3 and capacitor C1 to remove a noise component. At this time, depending on the resistance of resistor R3 set to 40 kΩ and the capacitance of 50 pF which is a capacitance falling within the range which can be formed in the motor current detecting IC, a time constant is set to be 2 μsec.

As shown in Fig. 1, in general, control circuit 102 and a circuit ground GND of a current detecting circuit are are arranged on the left of current detecting low-resistance resistor 150d, i.e., a side which is not connected to the switching element. For this reason, when the motor current is negative, i.e., when a current flows from the left side to the right side in Fig. 1 in current detecting low-resistance resistor 150d, a negative voltage is input to input terminal T1 of motor current detecting IC 101 in Fig. 2.

Therefore, in the present invention, in order to increase a withstand voltage of input terminal T1 to a negative voltage, input terminal T1 being probably applied with a negative voltage of the motor current detecting IC, protecting unit 118 may be provided such as a surge protecting element which is described in detail in the following embodiment.

When current detecting low-resistance resistor 150d is set in an open state by burnout, a soldering error, or the like, on the right side of current detecting low-resistance resistor 150d in Fig. 1, i.e., on the switching element side, a high voltage of the inverter circuit may be applied to input terminal T1 of motor current detecting IC 101 in Fig. 2.

In the present invention, blocking unit 119 (will be described later in detail in the following embodiment) may be provided which blocks a current inflow path when a large current flows in input terminal T1 with which an overvoltage of motor current detecting IC 101 may be applied. In this manner, a configuration which does not cause explosion, firing, or the like of a resin package of motor current detecting IC 101 can be obtained to make it possible to prevent troubles from occurring.

A design value of each of the constants of the components of the motor control apparatus described above is only an example, and varies depending on conditions such as current values of the motors, an output voltage to the control unit, and the like.

A circuit block configuration of the motor current detecting IC shown in Fig. 2 is an example. For example, polarities of input terminals T1 and T2 and an input to the differential amplifying circuit and the configuration of the differential amplifying circuit may be changed.

According to the first embodiment, an overcurrent detecting circuit configured by a comparing circuit is arranged in the motor current detecting IC to make it possible to prevent the switching element of the inverter circuit from being damaged and to prevent the wiring of the motor from being short-circuited.

According to the first embodiment, when a motor current detector is arranged through common current detecting low-resistance resistor 150d, a reduction in size and a reduction in cost of the motor current detector and a motor control apparatus including a motor current detecting IC the mounting area of which is reduced by a small number of components can be realized. As a result, the present invention can be used in a motor control apparatus such as a fan motor having a relatively simple configuration.

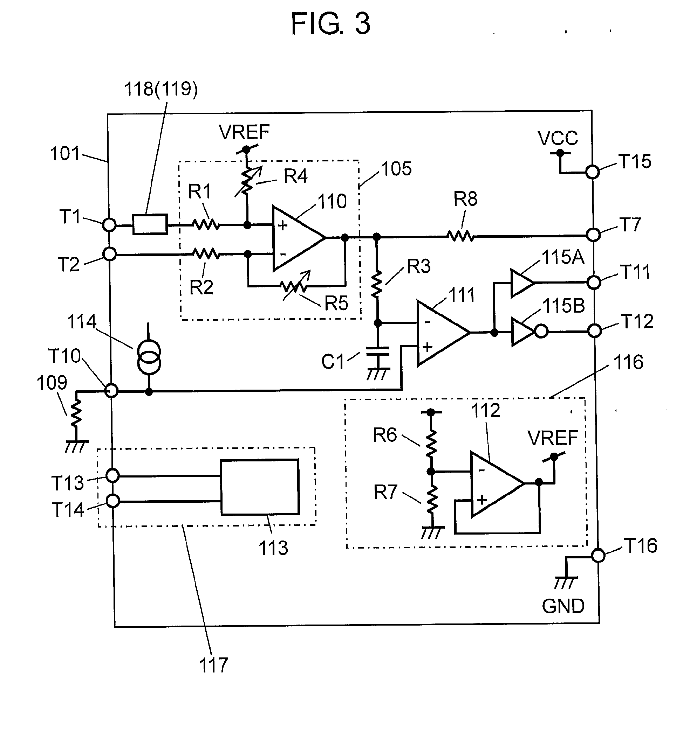

The first embodiment is described by the example in which a voltage of input terminal T1 of differential amplifying circuit 105 is input to a-(negative) side of comparing circuit 111 constituting overcurrent detecting circuit. However, the present invention is not limited to the configuration. For example, as will be described below with reference to Fig. 3, a voltage output from differential amplifying circuit 105 to output terminal T7 may be input to a - (negative) side of comparing circuit 111 constituting the overcurrent detecting circuit to detect an overcurrent.

A configuration and an operation of the overcurrent detecting circuit which detects a current level shown in another example of the motor current detecting IC will be described below with reference to Figs. 1 and 3.

Fig. 3 is a block diagram showing another example of the motor current detecting IC according to the first embodiment of the present invention.

As shown in Fig. 3, in the overcurrent detecting circuit, a voltage is input from an output on an output terminal T7 side of differential amplifying circuit 105 to, for example a - (negative) side serving as one input terminal of comparing circuit 111 through a low-pass filter configured by resistor R3 and capacitor C1. A voltage determined by current source 114 and detection value setting resistor 109 connected between detection value setting terminal T10 and a circuit GND is input to, for example, a + (positive) side serving as the other input terminal of comparing circuit 111. At this time, an overcurrent value to be detected is set by a resistance of detection value setting resistor 109.

More specifically, when the resistance of current detecting low-resistance resistor 150d shown in Fig. 1 is set to 50 mΩ and the maximum value of a current of the motor is 6 A, a description will be made on the assumption that a level of an overcurrent to be detected by comparing circuit 111 is set to 8 A.

A voltage of 50 mΩ x 8 A = 0.4 V is input to input terminals T1 and T2 shown in Fig. 3. At this time, as described above, when the resistances are set to $R_1 = R_2 = 40$ kΩ and $R_4 = R_5 = 200$ kΩ, output voltage $V_{OUT}$ of differential amplifying circuit 105 is given by Vout = 2.5 V + 200 kΩ/40 kΩ × 0.4 V = 4.5 V according to equation (2).

At this time, a resistance or the like of, for example, detection value setting resistor 109 is set to invert an output from comparing circuit 111. For example, when an output current from current source 114 is assumed to be 100 μA, a resistor having a resistance of 4.5 V/100 μA = 45 kΩ is connected between detection value setting terminal T10 and the circuit GND as detection value setting resistor 109. In this manner, when an overcurrent of 8 A flows in current detecting low-resistance resistor 150d having a resistance of 50 mΩ, a voltage of 4.5 V is generated on the output side of differential amplifying circuit 105 and input to one input terminal of comparing circuit 111. Comparing circuit 111 compares the voltage input to one input terminal of comparing circuit 111 with a voltage (4.5 V) set by detection value setting resistor 109 and input to the other input terminal of comparing circuit 111. At this time, when the voltage input to one input terminal of comparing circuit 111 is 4.5 V or more, an output from comparing circuit 111 is inverted to make it possible to detect flowing of an overcurrent of 8 A.

More specifically, when a voltage detected at input terminal T1 of differential amplifying circuit 105 by current detecting low-resistance resistor 150d reaches a value determined by a resistance of detection value setting resistor 109 connected to detection value setting terminal T10 of comparing circuit 111, comparing circuit 111 outputs a Low signal from output terminal T11 through buffer circuit 115A. At the same time, comparing circuit 111 outputs a High signal from output terminal T12 through inverting circuit 115B.

The output signal is input to control circuit 102 as overcurrent detecting signal OC, and can be used to protect the switching element of, for example, the inverter circuit or prevent the winding of the motor from being short-circuited.

According to another example of the first embodiment, the same effect as that in the above embodiment can be obtained, and a voltage input to the comparing circuit can be made high. For this reason, detection accuracy can be improved.

Each of the constants of the components described above is only an example, and the values vary depending on conditions such as a current value of the motor and an output voltage to the control circuit. The internal block configuration of the motor current detecting IC is an example. For example, the polarities of inputs to input terminals T1 and T2 and the differential amplifier and the configuration of the differential amplifier may be changed.


**(SECOND EMBODIMENT)**

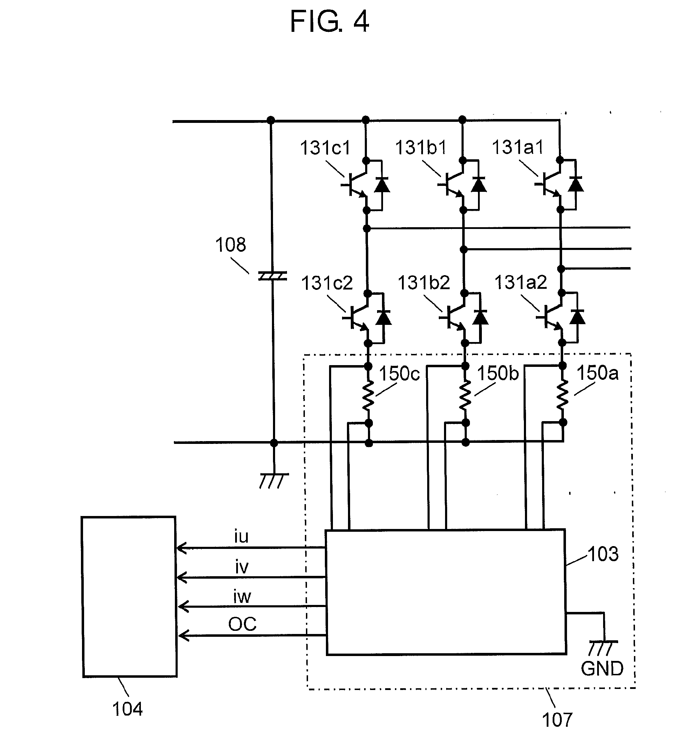

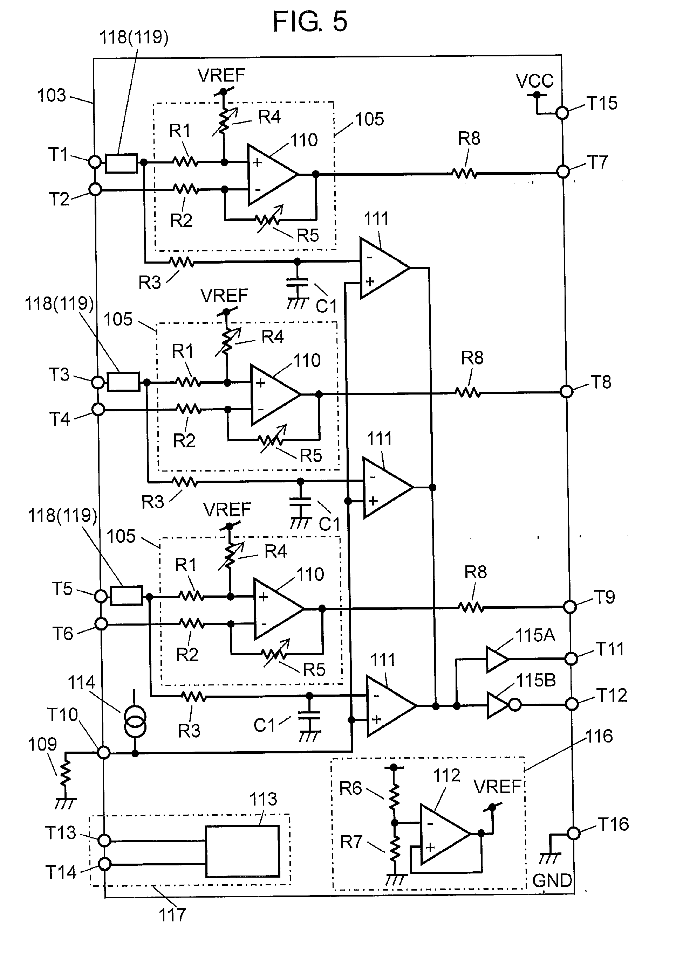

Fig. 4 is a block diagram of a motor control apparatus using a motor current detecting IC according to a second embodiment of the present invention. Fig. 5 is a block diagram of the motor current detecting IC according to the second embodiment.

Specifically, the second embodiment is different from the first embodiment, in that, especially, a motor current detector to which a motor current detecting IC connected to an inverter circuit and having a plurality of current signal amplifying circuits and a plurality of current detecting low-resistance resistors are connected and a comparing circuit are arranged. The other configuration of the second embodiment is the same as that in the first embodiment. In the second embodiment, especially in Fig. 5, a configuration related to parts, i.e., differential amplifying circuit 105, input terminals T1, T2, T3, T4, T5, and T6, output terminals T7, T8, and T9, comparing circuit 111, and detection value setting terminal T10 and output terminals T11 and T17 of comparing circuit 111 will be mainly described. At this time, three current signal amplifying circuits are configured by differential amplifying circuit 105 connected to one pair of input terminals T1 and T2 and output terminal T7, differential amplifying circuit 105 connected to one pair of input terminals T3 and T4 and output terminal T8, and differential amplifying circuit 105 connected to one pair of input terminals T5 and T6 and output terminal T9.

As shown in Fig. 4, an inverter circuit for driving a 3-phase motor is configured by a total of 6 switching elements, i.e., 3 parallel arranged sets of pairs of switching element 131a1 and switching element 131a2, switching element 131b1 and switching element 131b2, and switching element 131c1 and switching element 131c2 each pair of which are connected in series with each other. At this time, as the switching element, for example, an IGBT is used.

A connection point to which one pair of switching elements, for example, an emitter side (lower side) of switching element 131a1 and a collector side (upper side) of switching element 131a2 are connected is connected to a motor (not shown). One ends of current detecting low-resistance resistors 150a, 150b, and 150c are connected to the emitter sides of lower switching elements 131a2, 131b2, and 131c2 which are connected in series with each other. On the other hand, the other ends of current detecting low-resistance resistors 150a, 150b, and 150c are connected to a negative side of the power supply of the inverter circuit and a (negative) side of electrolytic capacitor 108. Both the ends of electrolytic capacitor 108 are connected to a rectifying circuit which rectifies a commercial AC power supply (not shown in Fig. 4). At this time, when a voltage doubler rectifying circuit having, for example, a single-phase AC of 100 V or a full-wave rectifying circuit having a single-phase or three-phase AC of 200 V is connected, a DC voltage of about 280 V is applied across both the ends of electrolytic capacitor 108.

Both the ends of current detecting low-resistance resistors 150a, 150b, and 150c are connected to motor current detecting IC 103, and motor current detector 107 is configured by current detecting low-resistance resistors 150a, 150b, and 150c and motor current detecting IC 103. The example in which motor current detector 107 is incorporated in the motor control apparatus has been described above. However, the motor control apparatus can also be configured as a single motor current detector by current detecting low-resistance resistors 150a, 150b, and 150c and motor current detecting IC 101.

As shown in Fig. 4, control circuit 104 is configured by mainly using, for example, a microcomputer (not shown), and current detecting signals iu, iv, and iw output from motor current detector 107 are input to an A/D converting port of the microcomputer. Control circuit 104 controls the gate signals of switching elements 131a1, 131a2, 131b1, 131b2, 131c1, and 131c2 of the inverter circuit to drive the motor. At this time, as motor currents which drive the motors, for example, when lower switching elements 131a2, 131b2, and 131c2 of the inverter circuit are turned on and upper switching, elements 131a1,131b1, and 131c1 of the inverter circuit are turned off, winding currents of all the three-phase motors can be detected through current detecting low-resistance resistors 150a, 150b, and 150c and motor current detecting IC 103 regardless of the directions of the currents.

As shown in Fig. 4, both the ends of current detecting low-resistance resistor 150a of the inverter circuit are connected to input terminals T1 and T2 shown in Fig. 5. Similarly, both the ends of current detecting low-resistance resistor 150b are connected to input terminals T3 and T4 shown in Fig. 4, and both the ends of current detecting low-resistance resistor 150c are connected to input terminals T5 and T6 shown in Fig. 5.

As shown in Fig. 4, in motor current detecting IC 103, voltages at both the ends of current detecting low-resistance resistors 150a, 150b, and 150c are amplified by AMPs 110 of differential amplifying circuits 105 and output to control circuit 104 as analog current detecting signals iu, iv, and iw through output terminals T7, T8, and T9. Current detecting signals iu, iv, and iw input to the microcomputer or the like of control circuit 104 are A/D-converted by control circuit 104 and then used as a current detection value for speed control, torque control, and the like of the motor.

An operation of the differential amplifying circuit of motor current detecting IC 101 is the same as that in the first embodiment, and therefore a description thereof will be omitted.

As shown in Fig. 4, motor current detecting IC 103 according to the second embodiment has an overcurrent detecting circuit configured by a comparing circuit (comparator) which detects a detection current value in which a current level of an overcurrent or the like is set, and outputs detected overcurrent detecting signal OC to control circuit 104.

A configuration and an operation of the overcurrent detecting circuit which detects a current level corresponding to a set detection current value will be described below with reference to Figs. 4 and 5.

As shown in Fig. 5, the overcurrent detecting circuit includes a plurality of comparing circuits corresponding to the phases of, for example, 3-phase motors, detection value setting terminal T10 commonly connected to the plurality of comparing circuits, and output terminals T11 and T12 commonly connected to the plurality of comparing circuits.

More specifically, voltages are input from input terminals T1, T3, and T5 of differential amplifying circuits 105 respectively constituting 3-phase current signal amplifying circuits to, for example, - (negative) sides serving as one input terminals of the plurality of comparing circuits 111 through low-pass filters configured by resistors R3 and capacitors C1. A voltage determined by current source 114 and detection value setting resistor 109 (not shown) connected between detection value setting terminal T10 and a circuit GND is input to, for example, + (positive) sides serving as the other input terminals of the plurality of comparing circuits 111. At this time, the other input terminals of the plurality of comparing circuits 111 are commonly connected to each other and connected to one detection value setting terminal T10.

For one detection value setting terminal T10, by a resistance of detection value setting resistor 109 connected outside, a detection current value to be detected can be arbitrarily set depending on characteristics required for the motor current detecting IC. Detection value setting resistor 109 may be formed in the motor current detecting IC to plan to further reduce in size of the configuration.

In this case, a description will be made by using the numerical values in the first embodiment. When any one voltage of voltages detected by current detecting low-resistance resistors 150a, 150b, and 150c at input, terminals T1, T3, and T5 of differential amplifying circuit 105, i.e., a value determined by a resistance (4.5 kΩ) of detection value setting resistor 109 connected to detection value setting terminal T10 commonly connected to the other input terminals of the plurality of comparing circuits 111 reaches 0.4 V or more, output terminal T11 outputs a Low signal from one output terminal commonly connected to the output terminals of the plurality of comparing circuits 111 through buffer circuit 115A. At the same time, output terminal T12 outputs a High signal from one output terminal of the plurality of comparing circuits 111 through inverting circuit 115B.

The output Low signal or the output High signal, as shown in Fig. 4, is input to control circuit 104 as overcurrent detecting signal OC.

According to the second embodiment, the overcurrent detecting circuit configured by the plurality of comparing circuits is arranged in the motor current detecting IC to detect an overcurrent in each of the phases by a set detection current value, and damage to the switching element of the inverter circuit or a short circuit of the winding of the motor can be effectively prevented.

According to the second embodiment, drive currents of the 3-phase motors can be detected and controlled by the motor current detector configured by the current detecting low-resistance resistors independently arranged in the phases (U-phase, V-phase, and W-phase). The motor current detector which detects drive currents of the 3-phase motors is formed in one motor current detecting IC to realize a reduction in size, a reduction in cost, and a reduction in number of components of the motor current detector, and a mounting area can be reduced. Furthermore, the motor current detecting IC is arranged to make it possible to realize a small-sized motor control apparatus at low cost. As a result, the present invention can be used in a motor control apparatus which requires relatively highly-advanced control, as in vector control of an induction motor or a brushless motor.

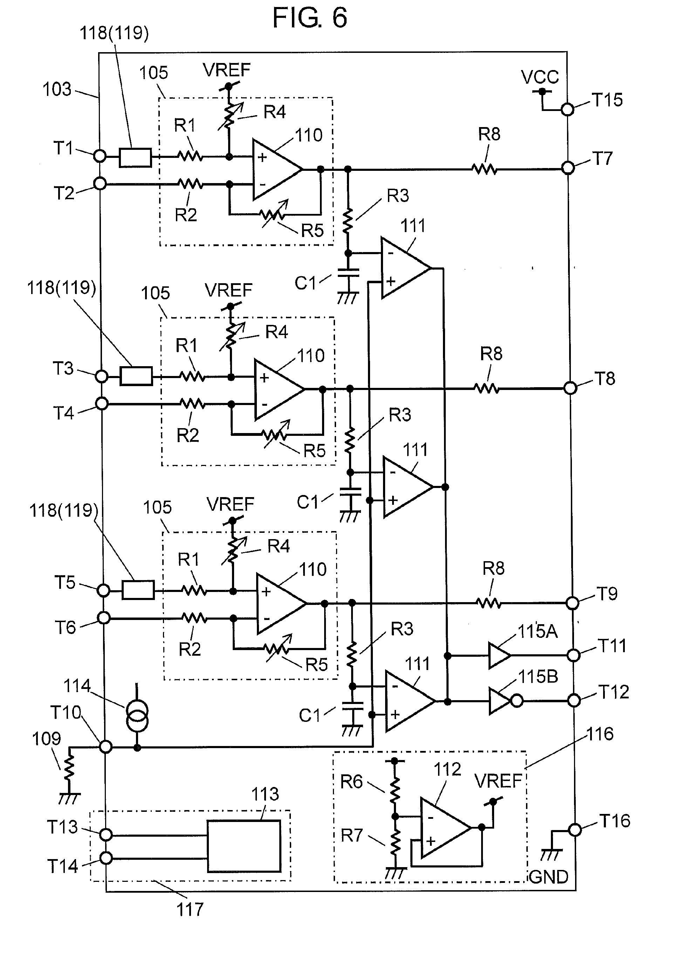

The second embodiment is described by the example in which voltages of input terminals T1, T3, and T5 of differential amplifying circuit 105 are input to - (negative) sides of comparing circuits 111 constituting overcurrent detecting circuit and arranged to correspond to the phases. However, the present invention is not limited to the configuration. For example, as will be described below with reference to Fig. 6, voltages output from differential amplifying circuit 105 to output terminals T7, T8, and T9 may be input to - (negative) sides of comparing circuits 111 constituting the overcurrent detecting circuit and arranged to correspond to the phases to detect an overcurrent.

A configuration and an operation of the overcurrent detecting circuit which detects a current level corresponding to a set detection current value shown in another example of the motor current detecting IC will be described below with reference to Figs. 4 and 6.

Fig. 6 is a block diagram showing another embodiment of the motor current detecting IC according to the second embodiment of the present invention.

As shown in Fig. 6, in the overcurrent detecting circuit, a voltage is input from outputs on the sides of input terminal T7, T8, and T9 of differential amplifying circuit 105 respectively constituting 3-phase current signal amplifying circuits to, for example, - (negative) sides serving as one input terminals of the plurality of comparing circuits 111 through low-pass filters configured by resistors R3 and capacitors C1. A voltage determined by current source 114 and detection value setting resistor 109 connected between detection value setting terminal T10 and a circuit GND is input to, for example, + (positive) sides serving as the other input terminals of the plurality of comparing circuits 111. At this time, the other input terminals of the plurality of comparing circuits 111 are commonly connected to each other and connected to one detection value setting terminal T10.

For one detection value setting terminal T10, by a resistance of detection value setting resistor 109 connected outside, a detection current value to be detected can be arbitrarily set depending on characteristics required for the motor current detecting IC. Detection value setting resistor 109 may be formed in the motor current detecting IC to plan to further reduce in size of the configuration.

In this case, a description will be made by using the numerical values in another example of the first embodiment. When any one voltage of voltages detected by current detecting low-resistance resistors 150a, 150b, and 150c at input terminals T1, T3, and T5 of the plurality of differential amplifying circuits 105, i.e., a value determined by a resistance ($45 \, k\Omega$) of detection value setting resistor 109 connected to detection value setting terminal T10 commonly connected to the other input terminals of the plurality of comparing circuits 111 reaches 4.5 V or more, output terminal T11 outputs a Low signal from one output terminal commonly connected to the output terminals of the plurality of comparing circuits 111 through buffer circuit 115A. At the same time, output terminal T12 outputs a High signal from one output terminal of the plurality of comparing circuits 111 through inverting circuit 115B.

The output signal Low signal or the output High signal, as shown in Fig. 4, is input to control circuit 104 as overcurrent detecting signal OC, and can be used to protect the switching element of, for example, the inverter circuit or prevent the winding of the motor from being short-circuited.

More specifically, when overcurrent detecting signal OC is input to control circuit 104, control circuit 104 immediately blocks gate signals of switching elements 131a1, 131a2, 131b1, 131b2, 131c1, and 131c2 of the inverter circuit to prevent switching elements 131a1, 131a2, 131b1, 131b2, 131c1, and 131c2 from being broken down.

According to another example of the second embodiment, the same effect as that in the above embodiment can be obtained, and a voltage input to the comparing circuit can be made high. For this reason, detection accuracy can be improved.

**(THIRD EMBODIMENT)**

A motor current detecting IC according to a third embodiment of the present invention will be described below with reference to Figs. 1 to 6.

The motor current detecting IC according to the third embodiment has a configuration in which a gain setting portion which makes it possible to adjust or select a gain of a differential amplifying circuit is arranged. The other configuration is the same as that of each of the motor current detecting ICs according to the first embodiment and the second embodiment.

That is, as shown in Figs. 2, 3, 5 and 6, gain setting portion 117 is configured by gain setting unit 113 arranged in motor current detecting IC 101 and input terminals T13 and T14 serving as gain setting terminals connected to gain setting unit 113.

In the third embodiment, since two input terminals T13 and T14 are used, for example, if input terminals T13 and T14 are inputs for digital signals, states of four types can be set by combinations of digital signals input to input terminals T13 and T14 in the outside or an ON/OFF signal from control circuit 104, and the like. Depending on the states of four types of input terminals T13 and T14, resistances of resistors R4 and R5 of differential amplifying circuit 105 can be variably changed by gain setting unit 113. For example, as described in the first embodiment, when the resistances of resistors R1 and R2 are set to 40 kΩ, gain setting unit 113 variably sets the resistances of resistors R4 and R5 to 100 kΩ, 200kΩ, 400kΩ, and 800kΩ at once depending on states of input terminals T13 and T14. In this manner, the gains of differential amplifying circuit 105 are set to 2.5 times, 5 times, 10 times, and 20 times, respectively.

More specifically, when a current value of a motor to be controlled is small (for example, the current value is up to 1 A), a resistance of current detecting low-resistance resistor 150d shown in Fig. 1 or resistances of current detecting low-resistance resistors 150a, 150b, and 150c shown in Fig. 4 are set to 1Ω, and a current gain is set to 2.5 times. In this manner, even though the current value of the motor is small, current detection which is excellent in an S/N ratio is possible.

On the other hand, when a current value of the motor is large, the resistance is preferably lowered as much as possible because a power loss of the current detecting resistor becomes large. When the maximum current detection value is 20 A, a resistance of current detecting low-resistance resistor 150d shown in Fig. 1 or resistances of current detecting low-resistance resistors 150a, 150b, and 150c shown in Fig. 4 is set to 10 mΩ, and a current gain is set to 20 times. In this manner, motor current detector 106 and 107 in which power losses by the current detecting low-resistance resistor are suppressed can be configured.

According to the third embodiment, when the gain of differential amplifying circuit 105 is arbitrarily set, the motor current detecting IC can cope with current detection for a motor in a wide range.

The third embodiment describes the example in which the gains of four types are set in the differential amplifying circuit by using the two gain setting terminals. However, the present invention is not limited to the example, and the number of gain setting terminals may be set to a number other than 2. For example, one gain setting terminal may be used, and a gain of the differential amplifying circuit may be set in 2 steps, for example, 5 times and 10 times or the like. Furthermore, three gain setting terminals may be used, and gains of 5 or more types may also be set in the differential amplifying circuit.

The third embodiment describes the example in which the gain of the differential amplifying circuit is digitally set. However, the gain of the differential amplifying circuit may be analogically set. In this case, for example, the above configuration is realized such that one gain setting terminal is used, and a resistor is connected between gain setting terminal and a circuit GND to input an analog signal, and the resistances of resistors R4 and R5 are made linearly set by using a current-mirror circuit in gain setting unit 113.

**(FOURTH EMBODIMENT)**

A motor current detecting IC according to a fourth embodiment of the present invention will be described below with reference to Figs. 2 and 3 while referring to the first embodiment.

The fourth embodiment has a configuration in which a power supply voltage of the motor current detecting IC is set as a single voltage of 5 V or the like by a single power supply. The other configuration is the same as that of each of the motor current detecting ICs according to the first to third embodiments.

More specifically, as shown in Figs. 2 and 3, terminal T15 of motor current detecting IC 101 is a power supply input terminal on a + (positive) side, and is connected to an internal power supply VCC of motor current detecting IC 101. Terminal T16 of motor current detecting IC 101 is connected to internal ground GND of motor current detecting IC 101 with a ground terminal.

Specifically, as described in the first embodiment, motor current detecting IC 101according to the present invention can allow input to a negative voltage by arranging protecting unit 118 on an input terminal, and the power supply of motor current detecting IC 101 can be given as a single power supply of, for example, + 5 V.

In this manner, the same power supply can be shared by motor current detecting IC 101 and the microcomputer and the logic circuit constituting the control circuit. As a result, a dedicated power supply inherent in an analog circuit is made unnecessary, and the current detecting circuit and the control circuit can be reduced in size.

**(FIFTH EMBODIMENT)**

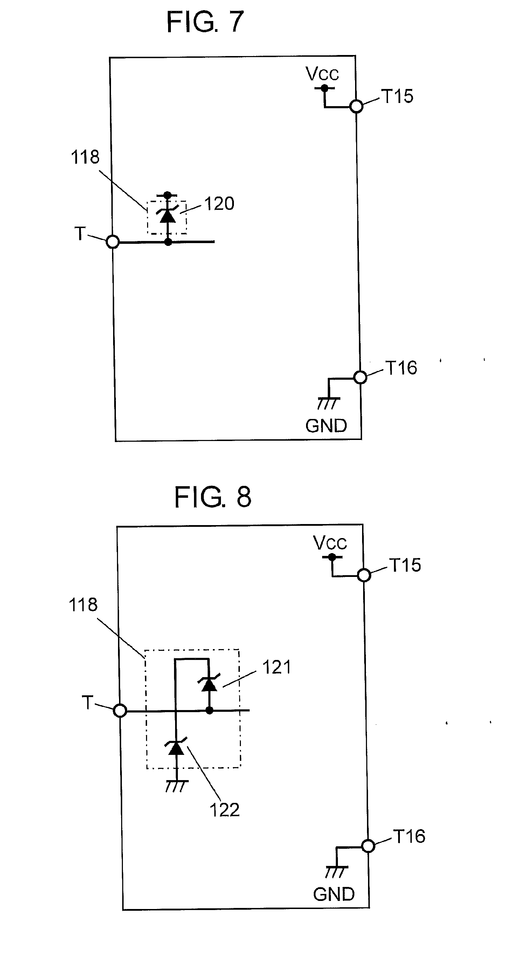

A motor current detecting IC according to a fifth embodiment of the present invention will be described below with reference to Fig. 7 while referring to the first embodiment.

The fifth embodiment has a configuration in which protecting unit 118 is arranged between a portion near a wire bonding pad connected to input terminal T of differential amplifying circuit 105 of motor current detecting IC 101 and a positive side of the power supply voltage of the motor current detecting IC. The other configuration is the same as that of the motor current detecting IC according to the first embodiment.

Fig. 7 is an explanatory diagram of a protecting unit of a motor current detecting IC according to the fifth embodiment of the present invention. In Fig. 7, constituent elements except for the protecting unit are not shown.

As shown in Fig. 7, input terminal T is an input terminal which is used to apply a negative voltage to a differential amplifying circuit of motor current detecting IC 101 and corresponds to input terminal T1 in the first embodiment. On the other hand, when the negative voltage is input to input terminal T2, input terminal T2 corresponds to input terminal T. Internal power supply VCC of motor current detecting IC 101 is supplied from the outside through terminal T15. The internal ground GND of motor current detecting IC 101 is connected to an external circuit ground through terminal T16.

As shown in Fig. 7, protecting unit 118 configured by surge protecting element 120 such as a zener diode is connected between input terminal T of motor current detecting IC 101 and internal power supply VCC.

Surge protecting element 120 serving as protecting unit 118 has characteristics similar to those of a zener diode and has a withstand voltage sufficiently higher than the power supply voltage. For example, when the power supply voltage of motor current detecting IC 101 is 5 V, surge protecting element 120 having a withstand voltage of at least about 7 V or more needs to be arranged.

An operation of surge protecting element 120 of the protecting unit will be described below.

When a positive surge voltage is applied to input terminal T of motor current detecting IC 101, surge protecting element 120 clamps a surge voltage at a value obtained by adding a forward voltage of the zener diode to the power supply voltage of motor current detecting IC 101 according to the same forward voltage characteristics as those of the zener diode. For example, when the power supply voltage of motor current detecting IC 101 is +5 V, the surge voltage on the positive voltage side is clamped at about +5.7 V

On the other hand, when a negative surge voltage is applied to input terminal T of motor current detecting IC 101, surge protecting element 120 clamps the surge voltage at a value obtained by subtracting a zener voltage of the zener diode from the power supply voltage of motor current detecting IC 101. For example, when the power supply voltage of motor current detecting IC 101 is +5 V and a withstand voltage of surge protecting element 120 is 7 V, the surge voltage on the negative voltage side is clamped at -2 V.

In this manner, even though the negative voltage is applied to input terminal T of differential amplifying circuit 105, a leakage current does not flow through surge protecting element 120. For this reason, the negative voltage can be applied to input terminal T. As a result, as described in the first embodiment, even though a motor current is negative, a trouble such as breakdown of motor current detecting IC 101 does not occur. For this reason, a current of a motor can be accurately detected.

In the fifth embodiment, although the first embodiment is exemplified, the present invention is not limited to the first embodiment. Even though the present invention is applied to the second to fourth embodiments, the same effect as described above can be obtained.

**(SIXTH EMBODIMENT)**

A motor current detecting IC according to a sixth embodiment of the present invention will be described below with reference to Fig. 8 while referring to the first embodiment.

The sixth embodiment is different from the fifth embodiment in that two surge protecting elements are connected in series with the polarities confronting each other between a portion near a wire bonding pad connected to input terminal T of differential amplifying circuit 105 of motor current detecting IC 101 and an internal ground of the motor current detecting IC to constitute protecting unit 118. The other configuration is the same as that of the motor current detecting IC according to the first embodiment.

Fig. 8 is an explanatory diagram of a protecting unit of a motor current detecting IC according to the sixth embodiment of the present invention. In Fig. 8, constituent elements except for the protecting unit are not shown.

As shown in Fig. 8, input terminal T is an input terminal which is used to apply a negative voltage to a differential amplifying circuit of motor current detecting IC 101 and corresponds to input terminal T1 in the first embodiment. On the other hand, when the negative voltage is input to input terminal T2, input terminal T2 corresponds to input terminal T. Internal power supply VCC of motor current detecting IC 101 is supplied from the outside through terminal T15. The internal ground GND of motor current detecting IC 101 is connected to an external circuit ground through terminal T16.

As shown in Fig. 8, two surge protecting elements 120 and 121 such as zener diodes are connected in series with polarities confronting each other between input terminal T of motor current detecting IC 101 and internal ground GND to obtain protecting unit 118.

The surge protecting elements constituting protecting unit 118 have characteristics similar to those of a zener diode. At least surge protecting element 121 has a withstand voltage of about 2 V or more, and surge protecting element 122 has a withstand voltage sufficiently higher than the power supply voltage of motor current detecting IC 101.

Operations of surge protecting elements 120 and 121 constituting protecting unit 118 will be described below.

When a positive surge voltage is applied to input terminal T of motor current detecting IC 101, surge protecting element 121 operates according to the forward voltage characteristics of a zener diode, and surge protecting element 122 operates according to the zener voltage characteristics of a zener diode. For this reason, a surge voltage is clamped at a value obtained by adding a forward voltage and a zener voltage to each other. For example, when the power supply voltage of motor current detecting IC 101 is +5 V and a withstand voltage of surge protecting element 122 is 7 V, the surge voltage on the positive voltage side is clamped at about +7.7 V.

When a negative surge voltage is applied to input terminal T of motor current detecting IC 101, surge protecting element 121 operates according to the zener voltage characteristics of a zener diode, and surge protecting element 122 operates according to the forward voltage characteristics of a zener diode. For example, when the withstand voltage of surge protecting element 121 is 2 V, the surge voltage on the negative voltage side is clamped at -2.7 V.

In this manner, even though the negative voltage is applied to input terminal T of differential amplifying circuit 105, a leakage current does not flow through the surge protecting element. For this reason, the negative voltage can be applied to input terminal T. As a result, as described in the first embodiment, even though a motor current is negative, a trouble such as breakdown of motor current detecting IC 101 does not occur. For this reason, a current of a motor can be accurately detected.

In the sixth embodiment, although the first embodiment is exemplified, the present invention is not limited to the first embodiment. Even though the present invention is applied to the second to fourth embodiments, the same effect as described above can be obtained.

## (SEVENTH EMBODIMENT)

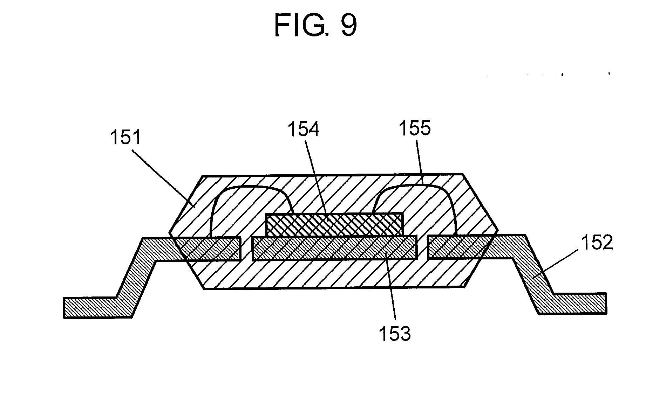

A motor current detecting IC according to a seventh embodiment of the present invention will be described below with reference to Fig. 9 while referring to the first embodiment.

The seventh embodiment has a configuration in which blocking unit 119 which blocks a current is arranged between a lead frame which forms input terminal T1 of differential amplifying circuit 105 of motor current detecting IC 101 and a bonding pad on a silicon chip. The other configuration is the same as that of motor current detecting IC 101 according to the first embodiment.

Fig. 9 is an explanatory sectional view of a structure of a motor current detecting IC according to the seventh embodiment of the present invention.

As shown in Fig. 9, motor current detecting IC 101 is configured such that at least lead frame 152, base substrate 153, silicon chip 154, and bonding wire 155 which connects these parts to each other are molded with, for example, resin mold 151. Lead frame 152 and base substrate 153 are formed by punching out a lead frame. In general, base substrate 153 is shared by any one of plurality of lead frames 152. Silicon chip 154 is bonded on base substrate 153 with, for example, silver paste or the like. Bonding wire 155 electrically connects lead frame 152 to the bonding pad on silicon chip 154.

Resin mold 151 protects silicon chip 154 of motor current detecting IC 101 and bonding wire 155 and fixes lead frame 152.

In the seventh embodiment, bonding wire 155 connected to input terminal T1 of differential amplifying circuit 105 of at least motor current detecting IC 101 is fused by a predetermined current (for example, about 2 A). For example, the bonding wire is formed in a very-thin shape ($\phi$ 20 $\mu$m to $\phi$ 25 $\mu$m) to configure blocking unit 119. In general, other bonding wires 155 also have the same shapes as described above in consideration of productivity. However, the connection may be performed by bonding wires having different shapes.

An operation of the blocking unit will be described below with reference to the first embodiment and Figs. 1 and 2.

In general, when current detecting low-resistance resistor 150d shown in Fig. 1 is opened by, for example, burnout, a soldering error, or the like, a high voltage of the inverter circuit may be applied to input terminal T1 of motor current detecting IC 101 shown in Fig. 2 and connected to the switching element side of current detecting low-resistance resistor 150d. At this time, an overcurrent flowing in input terminal T1 of motor current detecting IC 101 flows via a protecting unit such as a surge protecting element through bonding wire 155 serving as blocking unit 119.

Bonding wire 155 serving as blocking unit 119 is fused by an overcurrent to block a subsequent overcurrent.

According to the seventh embodiment, even though a trouble in which a current detecting low-resistance resistor connected to, for example, motor current detecting IC is opened occurs, very-thin-shaped bonding wire 155 constituting blocking unit 119 is blown to make it possible to prevent the motor current detecting IC from being broken and firing.

In the seventh embodiment, although the first embodiment is exemplified, the present invention is not limited to the first embodiment. Even though the present invention is applied to the second to sixth embodiments, the same effect as described above can be obtained.

## (EIGHTH EMBODIMENT)

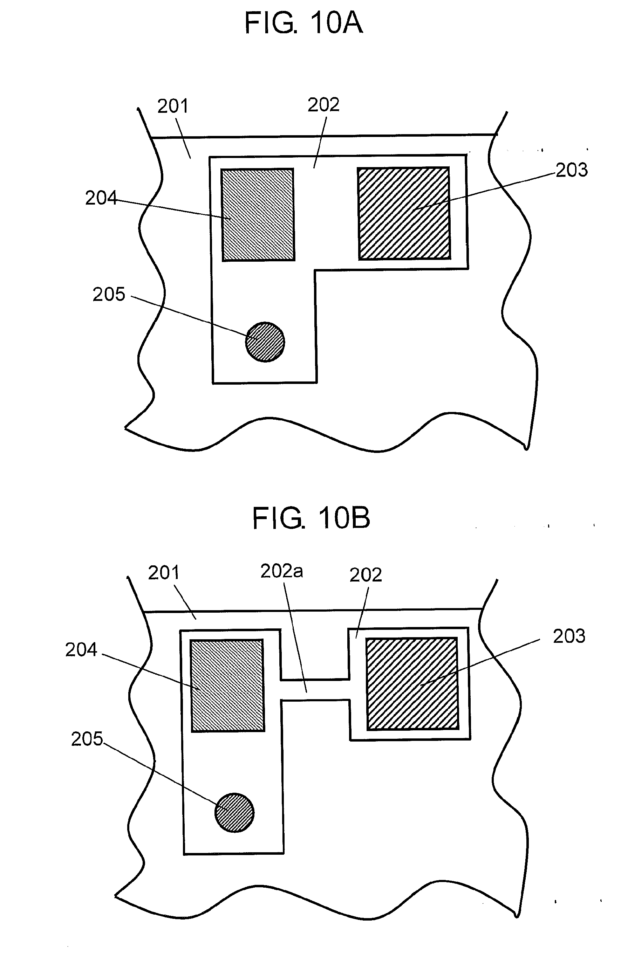

A motor current detecting IC according to an eighth embodiment of the present invention will be described below with reference to Figs. 10A and 10B while referring to the first embodiment.

The eighth embodiment has a configuration in which blocking unit 119 which blocks a current is arranged between a lead frame which forms input terminal T1 of differential amplifying circuit 105 of motor current detecting IC 101, a bonding pad on a silicon chip connected through a bonding wire, and another circuit including a surge protecting element serving as protecting unit 118. The other configuration is the same as that of motor current detecting IC 101 according to the first embodiment.

Fig. 10A is an explanatory partial plan view of a wiring near a bonding pad of a general IC. Fig. 10B is an explanatory partial plan view of a wiring having a blocking unit near a bonding pad of a motor current detecting IC according to the eighth embodiment of the present invention.

As shown in Figs. 10A and 10B, bonding pad 203 connected to a bonding wire on a surface of silicon chip 201 of the motor current detecting IC and surge protecting element 204 serving as a protecting unit are connected to each other by wiring 202 made of aluminum or the like. Furthermore, similarly, surge protecting element 204 is connected to the internal circuit of the motor current detecting IC by wiring 202 through, for example, contact hole 205.

In the eighth embodiment, as shown in Fig. 10B, thin-line portion 202a which is blown by a predetermined current (for example, about 2 A) and has a narrow width of, for example, 10 μm is formed in wiring 202 arranged between bonding pad 203 and surge protecting element 204 to form a blocking unit.

An operation of the blocking unit will be described below with reference to the first embodiment and Figs. 1 and 2.

In general, when current detecting low-resistance resistor 150d shown in Fig. 1 is opened by, for example, burnout, a soldering error, or the like, a high voltage of the inverter circuit may be applied to input terminal T1 of motor current detecting IC 101 shown in Fig. 2 connecting to the switching element side of current detecting low-resistance resistor 150d. At this time, an overcurrent flowing in input terminal T1 of motor current detecting IC 101 flows through narrow thin-line portion 202a of wiring 202 serving as the blocking unit which connects bonding pad 203 connected to the bonding wire and surge protecting element 204 serving as the protecting unit.

Narrow thin-line portion 202a of wiring 202 serving as the blocking unit is blown by an overcurrent to block a subsequent overcurrent.

According to the eighth embodiment, even though a trouble in which a current detecting low-resistance resistor connected to, for example, motor current detecting IC is opened occurs, narrow thin-line portion 202a constituting the blocking unit is blown to make it possible to prevent the motor current detecting IC from being broken and firing.

In the eighth embodiment, although the first embodiment is exemplified, the present invention is not limited to the first embodiment. Even though the present invention is applied to the second to seventh embodiments, the same effect as described above can be obtained.

### (NINTH EMBODIMENT)

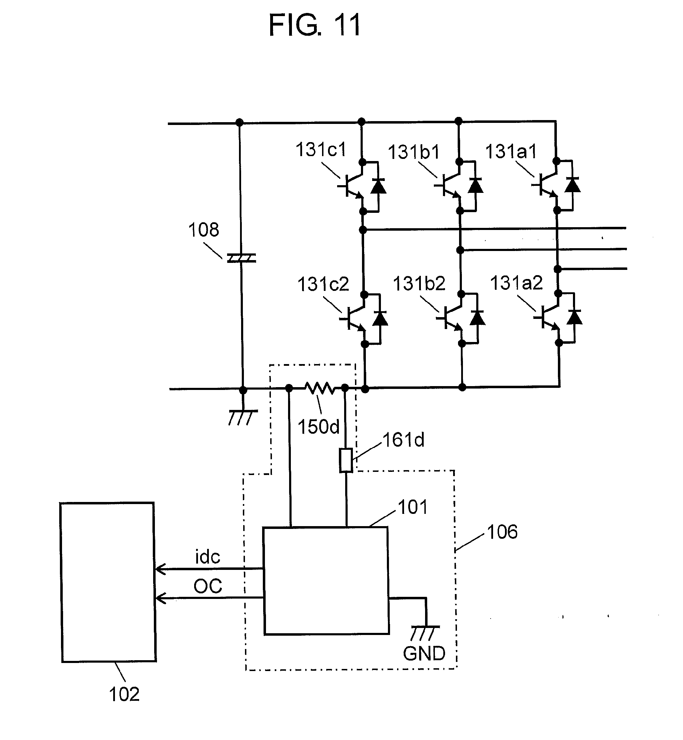

A motor current detector according to a ninth embodiment of the present invention and a motor control apparatus using the same will be described below with reference to Fig. 11 while referring to the first embodiment and Fig. 2.

The ninth embodiment is a motor control apparatus including motor current detector 106 obtained by connecting protecting element 161d between any one of input terminals of a differential amplifying circuit of motor current detecting IC 101 and current detecting low-resistance resistor 150d.

Fig. 11 is a block diagram of a motor control apparatus using a motor current detector according to the ninth embodiment of the present invention.

As shown in Fig. 11, motor current detector 106 is configured by current detecting low-resistance resistor 150d, motor current detecting IC 101, and protecting element 161d.

At this time, one end (for example, a side connected to the emitter terminal of lower switching elements 131a2, 131b2, and 131c2 of the inverter circuit) of current detecting low-resistance resistor 150d is connected to any one of input terminals T1 and T2 of motor current detecting IC 101 through protecting element 161d which suppresses or blocks an overcurrent. The other end (for example, a GND side of an electrolytic capacitor) of current detecting low-resistance resistor 150d is connected to the other one of input terminals T1 and T2 of the motor current detecting IC 101.

At this time, in general, when current detecting low-resistance resistor 150d shown in Fig. 11 is opened by, for example, burnout, a soldering error, or the like, a high voltage of the inverter circuit may be applied to input terminal T1 of motor current detecting IC 101 shown in Fig. 2 connecting to the switching element side of current detecting low-resistance resistor 150d. At this time, an overcurrent flowing in input terminal T1 of motor current detecting IC 101 flows via a protecting unit such as a surge protecting element through protecting element 161d. For this reason, protecting element 161d having an impedance sufficiently smaller than the resistances of resistors R1 and R2 in motor current detecting IC 101 is arranged to suppress or block the current.

As protecting element 161d in the ninth embodiment, a fuse or a resistor which is fused by a current can be used. For example, when protecting element 161d is a fuse, a fuse which is fused by a current of, for example, about 0.1 A is preferably used. This is because, when current detecting low-resistance resistor 150d functions in a normal state being free from burnout, a soldering error, or the like, a minute current (< 0.1 A) flows in protecting element 161d without fusing the fuse.

When protecting element 161d is a resistor, for example, a resistor which is easily fused by a large current flowing in the input terminal of motor current detecting IC 101 when current detecting low-resistance resistor 150d is opened is selected, or a resistor having a resistance and a power durability which can sufficiently suppress a current to prevent the motor current detecting IC 101 from being exploded or firing is selected.

According to the ninth embodiment, when current detecting low-resistance resistor 150d is opened, a large current flowing in the input terminal of motor current detecting IC 101 can be suppressed by protecting element 161d. As a result, motor current detector 106 which prevents motor current detecting IC 101 from being exploded or firing and is excellent in reliability and safety or a motor control apparatus using the same can be realized.

**(TENTH EMBODIMENT)**

A motor current detector according to a tenth embodiment of the present invention and a motor control apparatus using the same will be described with reference to Fig. 12 while referring to the second embodiment and Fig. 4.

The tenth embodiment is a motor control apparatus including motor current detector 107 obtained by connecting protecting elements 161a, 161b, and 161c between any one of input terminals of each of differential amplifying circuits of a plurality of current signal amplifying circuits of motor current detecting IC 103 and current detecting low-resistance resistors 150a, 150b, and 150c arranged to correspond to the differential amplifying circuits.

Fig. 12 is a block diagram of a motor control apparatus using a motor current detector according to the tenth embodiment of the present invention.

As shown in Fig. 12, motor current detector 107 is configured by a plurality of current detecting low-resistance resistors 150a, 150b, and 150c, motor current detecting IC 103 having a plurality of current signal amplifying circuits, and protecting elements 161a, 161b, and 161c.

At this time, independent current detecting low-resistance resistors 150a, 150b, and 150c are connected to the emitter terminal of lower switching elements 131a2, 131b2, and 131c2 constituting the inverter circuit, respectively. Specifically, one end of current detecting low-resistance resistor 150a is connected to the emitter side of switching element 131a2, one end of current detecting low-resistance resistor 150b is connected to the emitter side of switching element 131b2, and one end of current detecting low-resistance resistor 150c is connected to the emitter side of switching element 131c2. The other ends of current detecting low-resistance resistors 150a, 150b, and 150c are connected to the GND side of electrolytic capacitor 108.

One end of current detecting low-resistance resistor 150a is connected to input terminals T1 and T2 of the motor current detecting IC 103 shown in Fig. 4 through protecting element 161a connected to lower switching element 131a2, and the other end of current detecting low-resistance resistor 150a is directly connected to input terminals T1 and T2 of motor current detecting IC 103 shown in Fig. 4.

Similarly, one end of current detecting low-resistance resistor 150b is connected to input terminals T3 and T4 of the motor current detecting IC 103 shown in Fig. 4 through protecting element 161b connected to lower switching element 131b2, and the other end of current detecting low-resistance resistor 150b is directly connected to input terminals T3 and T4 of motor current detecting IC 103 shown in Fig. 4. One end of current detecting low-resistance resistor 150b is connected to input terminals T3 and T4 of the motor current detecting IC 103 shown in Fig. 4 through protecting element 161b connected to lower switching element 131b2, and the other end of current detecting low-resistance resistor 150b is directly connected to input terminals T3 and T4 of motor current detecting IC 103 shown in Fig. 4.

At this time, in general, when current detecting low-resistance resistors 150a, 150b, and 150c of the motor control apparatus shown in Fig. 12 are opened by, for example, burnout, a soldering error, or the like, a high voltage of the inverter circuit may be applied to input terminals T1, T3, and T5 of current detecting low-resistance resistors 150a, 150b, and 150c. At this time, overcurrents flowing in input terminals T1, T3, and T5 of motor current detecting IC 103 flow via a protecting unit such as a surge protecting element through protecting elements 161a, 161b, and 161c. For this reason, protecting elements 161a, 161b, and 161c each having an impedance sufficiently smaller than the resistances of resistors R1 and R2 in motor current detecting IC 103 are arranged to suppress or block the current.

As protecting elements 161a, 161b, and 161c in the tenth embodiment, fuses or resistors which are fused by a current can be used. For example, when protecting elements 161a, 161b, and 161c are fuses, fuses which are fused by a current of, for example, about 0.1 A are preferably used. This is because, when current detecting low-resistance resistors 150a, 150b, and 150c function in a normal state being free from burnout, a soldering error, or the like, a minute current (< 0.1 A) flows in protecting element 161a, 161b, and 161c without fusing the fuse.

When protecting elements 161a, 161b, and 161c are resistors, for example, resistors which are easily fused by a large current flowing in the input terminal of motor current detecting IC 103 when current detecting low-resistance resistors 150a, 150b, and 150c are opened are selected, or resistors having resistances and power durability which can sufficiently suppress a current to prevent the motor current detecting IC 103 from being exploded or firing is selected.

According to the tenth embodiment, when current detecting low-resistance resistors 150a, 150b, and 150c are opened, a large current flowing in the input terminal of motor current detecting IC 103 can be suppressed by protecting elements 161a, 161b, and 161c. As a result, motor current detector 107 which prevents motor current detecting IC 103 from being exploded or firing and is excellent in reliability and safety or a motor control apparatus using the same can be realized.

The embodiments described above can be effected by combining them appropriately, and can be effected by combining some of the embodiments.

**Claims**

1.  A motor current detecting IC comprising:

    a comparing circuit having a detection value setting terminal which sets a detection current value;
    a current signal amplifying circuit having a differential amplifying circuit connected to the comparing circuit, one pair of input terminals connected to the differential amplifying circuit, and an output terminal connected to an output of the differential amplifying circuit; and
    a power supply terminal which supplies a power supply voltage to the current signal amplifying circuit, wherein the comparing circuit compares a voltage determined by a detection value setting resistor connected to the detection value setting terminal with a voltage input to any one of the pair of input terminals of the differential amplifying circuit or a voltage of the output terminal of the differential amplifying circuit and outputs a comparison result.

2.  The motor current detecting IC according to claim 1, comprising a plurality of pairs of current signal amplifying circuits and comparing circuits, each being identical with the current signal amplifying circuit and the comparing circuit, wherein each of the comparing circuits compaires a voltage determined by a detection value setting resistor connected to one detection value seting terminal with a voltage input to any one of the pair of input terminals of corresponding one of the differential amplifying circuits or a voltage output from the differential amplifying circuit, and outputs a comparison result from a common conjugated output of all the comparing circuits.

3.  The motor current detecting IC according to claim 1, comprising a gain setting unit for adjusting a gain of the differential amplifying circuit.

4.  The motor current detecting IC according to claim 1, wherein the power supply voltage is a single voltage.

5.  The motor current detecting IC according to claim 1, wherein the input terminal of the differential amplifying circuit has a protecting unit for allowing input of a negative voltage.

6.  The motor current detecting IC according to claim 5, wherein the protecting unit comprises a surge protecting element arranged between any one of the pair of input terminals of the differential amplifying circuit and the power supply terminal on the positive side of the power supply voltage.

7.  The motor current detecting IC according to claim 5, wherein the protecting unit comprises two surge protecting elements connected in series with the polarities confronting each other between any one of the pair of input terminals of the differential amplifying circuit and the power supply terminal on the negative side of the power supply voltage.

8.  The motor current detecting IC according to claim 1, wherein the input terminal of the differential amplifying circuit has a blocking unit which blocks a voltage equal to or larger than a predetermined voltage input to the input terminal.

9.  The motor current detecting IC according to claim 8, wherein the blocking unit comprises a bonding wire connecting at least a lead frame of any one of the pair of input terminals of the differential amplifying circuit and an electrode pad of a silicon chip.

10. The motor current detecting IC according to claim 8, wherein the blocking unit comprises a thin-line portion of a wiring on a silicon chip.

11. A motor control apparatus using a motor current detecting IC of any one of claims 1 to 10.

**12.** A motor current detector comprising:

a motor current detecting IC of any one of claims 1 to 10; and
a current detecting low-resistance resistor connected between the pair of input terminals of the differential amplifying circuit of the current signal amplifying circuit.

**13.** The motor current detector according to claim 12, wherein
a protecting element is connected between the current detecting low-resistance resistor and any one of the pair of input terminals of the differential amplifying circuit.

**14.** The motor current detector according to claim 13, wherein the protecting element comprises a fuse.

**15.** The motor current detector according to claim 13, wherein the protecting element comprises a resistor.

**16.** A motor control apparatus using a motor current detector of claim 13.

# FIG. 1

# FIG. 2

# FIG. 3

# FIG. 4

# FIG. 5

# FIG. 6

# FIG. 7

# FIG. 8

# FIG. 9

# FIG. 10A

# FIG. 10B

# FIG. 11

# FIG. 12

# FIG. 13

FIG. 14

# FIG. 15

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008054812 A